# EUROPEAN PATENT APPLICATION

(11) **EP 0 525 942 A2**
(43) Date of publication of application: **03.02.1993**
(21) Application number: 92304598.3
(22) Date of filing: 20.05.1992
(51) Int. Cl.: H01L 21/027, H01L 21/311, G03F 7/09, G03F 7/00, H01L 21/90

(54) **Integrated circuit fabrication process using a bilayer resist**

(30) Priority: 31.05.1991 US 708956
(71) Applicant: AT&T Corp., New York, NY 10013-2412 (US)
(72) Inventor: Cuthbert, John David, Bethlehem, Pennsylvania 18017 (US); Fu, Chong-Cheng, Allentown, Pennsylvania 18104 (US); Olasupo, Kolawole Rahman, Kutztown, Pennsylvania 19530 (US)
(74) Representative: Johnston, Kenneth Graham

(57) **Abstract**

A lithographic process for integrated circuit processing uses a two-level resist to reduce variations in nominally identical feature sizes as printed in the resist(e.g. 7) and as transferred into the substrate(e.g. 1), resulting from complex topography on the substrate surface.

## Description

### Technical Field

This invention relates to an integrated circuit fabrication process which uses a bilayer resist in a pattern delineation step.

### Background of the Invention

A typical integrated circuit fabrication process has several pattern delineation steps. In such steps, the substrate is coated with a photosensitive material, termed a *resist*, and selected portions are exposed to radiation which creates differential removal characteristics between the exposed and unexposed portions of the resist. After exposure, portions of the resist are removed thereby revealing the underlying substrate. Further processing steps, e.g., etching, ion implantation, etc., are now performed on the revealed portions of the substrate. The further processing steps often generate a location dependent height hₛ(x,y) and reflectivity Rₛ(x,y) of the substrate surface. The local height variations are typically referred to as the device topography.

When a photoresist is spun onto a wafer, the substrate topography causes both the resist thickness tᵣ(x,y) and its height (tᵣ + hₛ) to become location dependent. The variations in hₛ, tᵣ, and Rₛ may produce adverse effects as consideration of the following shows. Assuming that the depth of focus (DOF) of the imaging lens is greater than tᵣ + hₛ, the location-dependent variations in tᵣ and Rₛ can induce significant variations in absorbed energy, i.e., exposure, which in turn, because of the finite resolution of a real lens, induces significant variations in developed resist image sizes as compared to the intended sizes. If the DOF is less than tᵣ + hₛ, the slope of developed resist images will vary with location on the substrate and additional size variations will be encountered. In addition, radiation may be reflected from the edges of the substrate topography to produce reflective notching; i.e., a portion of the resist receives an undesirably large amount of radiation. These effects, unless controlled, will cause variations in the pattern dimensions transferred into the substrate by further processing steps such as etching and ion implantation. Accordingly, those skilled in the art have investigated several approaches in attempts to control these effects.

Several of these schemes use a multilevel resist. Such schemes, both bilevel and trilevel, are generally reviewed in "*Semiconductor Lithography*," by Wayne M. Moreau, Plenum Press, New York, 1988, pp. 584-600. As an example of a trilevel process, see *U. S. Patent 4,244,799*, issued on January 13, 1981 to Fraser et al. In an exemplary embodiment of this patent, a thick layer of a sacrificial material is deposited on a patterned substrate and is followed by a masking layer and a resist. The sacrificial layer may be opaque to the exposing radiation. The sacrificial and masking layers are sometimes referred to as planarizing and stencil layers, respectively. The planarizing layer has a bottom surface that conforms to the device topography and a relatively flat top surface. The top surface permits the stencil layer to be planar and the subsequenly spun on photoresist to have a uniform thickness. The resist has a highly planarized surface as deposited. The resist is patterned, i.e., selected portions of the resist are removed, to reveal selected portions of the stencil layer which is then etched to reveal the planarizing layer. The resist may then be stripped and the stencil layer used as the mask to etch the planarizing layer and reveal portions of the substrate. The stencil layer has a very low etch rate in the medium used to etch the planarizing layer.

Two-level schemes are simpler, at least in theory, than are three level schemes. A two level resist scheme is described in *U. S. Patent 4,521,274* issued on June 4, 1985 to Reichmanis et al. A planarizing antireflection coating (ARC) is spun on before the resist is deposited. The resist is patterned to reveal portions of the planarizing ARC and then used as a mask for patterning of the planarizing ARC and, if desired, the underlying material.

In practical applications, the production of a planarizing layer with a flat top for trilayer processes usually requires such a layer to be relatively thick (∼2µm) and to be baked at high temperatures. The deposition of stencil and planarizing layers, and the subsequent etching of these layers, is expensive and prone to defect formation. For some bilayer processes, the production of a sufficient etch rate differential between the resist and the underlying planarizing ARC layer is required and may be expensive and cause the formation of defects which degrade the devices being formed on the substrate.

### Summary of the Invention

A method for fabricating semiconductor integrated circuits comprising the steps of fabricating features on a substrate whereby said substrate has a nonplanar surface; covering said substrate and features with a planarizing ARC layer that is highly absorbing of radiation used in a subsequent step and is at least partially planarizing; coating said planarizing ARC layer with a resist; exposing selected portions of said resist to radiation thereby creating at least two features in said resist; and anisotropically etching said resist and said planarizing ARC layer to reveal selected portions of said substrate. The features represent prior topography.

In a preferred embodiment, the planarizing ARC layer and the resist have approximately equal etch rates. In another preferred embodiment, the planarizing ARC and the resist do not mix.

### Brief Description of the Drawings

FIG. 1 is a sectional view of an integrated circuit at an intermediate fabrication stage using a conventional process and is useful in defining some of the symbols employed in explaining the background of this invention; and
FIGs. 2-4 are sectional views of an integrated circuit at intermediate stages in a fabrication sequence according to this invention.

For reasons of clarity, the elements of the integrated circuit depicted are not drawn to scale. Identical numerals in different figures represent identical elements.

### Detailed Description

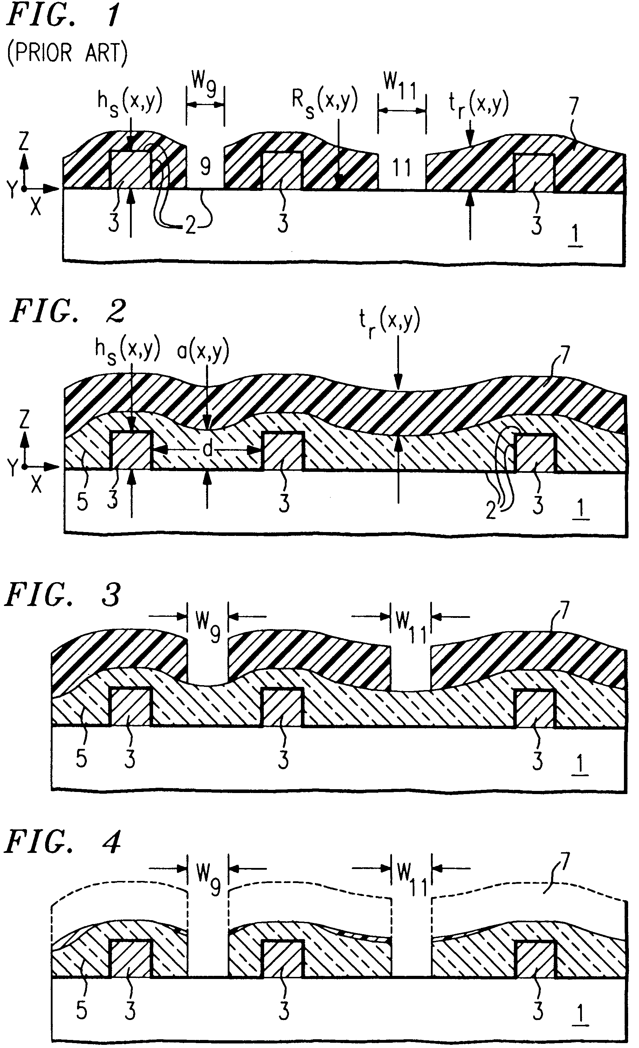

FIG. 1 represents a conventional single layer resist process in which resist was deposited directly onto the substrate. Depicted are substrate 1, which has features 3, and resist 7. The features 3 have position dependent heights hₛ (x,y), and the resist has a position dependent thickness tᵣ (x,y). A substrate surface 2 is shown as formed by previous processing steps performed on the exposed portions of the substrate. The term *substrate* is used to mean any material which lies beneath and supports another material. The substrate surface 2 may, as shown, comprise different materials. Rₛ (x,y) represents the position-dependent reflectivity of the substrate surface 2. The features 9 and 11 are shown as having been defined in resist by means well known in the semiconductor fabrication art. On the photomask, the features have identical widths. However, the difficulties of controlling the corresponding feature sizes in resist, as discussed in the Background of the Invention, are present in the single-layer process, with the consequence that the resist feature widths W₉ and W₁₁ are not generally equal. They can easily be different by more than 0.10µm.

A preferred embodiment of the invention will be described with respect to FIGs. 2-4. Other embodiments will be apparent to those skilled in the art after consideration of the following.

FIG. 2 is a sectional view of an integrated circuit at an intermediate stage in the fabrication process. Depicted are substrate 1, substrate surface 2, a plurality of features 3 in substrate 1, planarizing ARC layer 5, and resist 7. The *x*, *y* and *z* directions are also indicated. The features have a height hₛ, the antireflextion coating has typical thickness *a*(x,y), and the resist has a typical thickness tᵣ(x,y). The substrate features have a separation *d*, and it is apparent that *d* is not constant. The features, formed by prior processing, produce the substrate topography seen by the subsequently deposited partially planarizing ARC. It is apparent that the thickness of the antireflection coating, normally deposited by spin coating, is not constant but varies as *d* varies and that the resist is thinnest where the antireflection coating is highest. The planarizing ARC layer is typically thicker at the edges of topography and where *d* is smallest. Although layer 5 is referred to as an antireflection layer, it also has planarizing properties; that is, it is at least partially planarizing and may be completely planarizing. The term, planarizing ARC, will be used to refer to this layer.

The material requirements for the elements depicted merit several comments. The substrate 1 comprises any of the materials typically encountered in integrated circuit processing, such as silicon, which may have had some of its properties modified by, e.g., doping; or a dielectric such as a field oxide, etc. The features 3 represent deviations from substrate surface planarity and may be, e.g., conductive runners on a field oxide. Of course, other types of features may be used in our invention. The features depicted are thus only for pulses of illustration. There will also be some device features present which are not shown for reasons of clarity. Such elements are well known to those skilled in the art and need not be described in detail.

The planarizing ARC is an intense absorber of optical radiation of the wavelengths used to expose the resist. Thus, exposing radiation reaching the ARC is absorbed, thereby essentially eliminating the viable optical coupling of light unto the photoresist and the unintended variation of developed feature sizes in resist.

The planarizing ARC layer 5 may be quite thin. It is not necessary to produce a top surface which is flat, although the top surface is always much smoother than is the underlying substrate. That is, layer 5 is at least partially planarizing. The thickness of the layer is adjusted so that, where topography causes the ARC to be thinned down, it is still an effective ARC with the local reflectance reduced to about 10 percent or less of that without the ARC. A typical planarizing ARC thickness is about .4µm. Further properties of this planarizing ARC are that it is non-soluble (or very mildly soluble) in photoresist developer and is sufficiently transparent at the alignment wavelengths to not interfere with alignment procedures. Any organic material that volatilizes during etching and leaves no residue may be used for the planarizing ARC layer provided it has the needed optical properties. For example, hardbaked novolac resins or other resists may be used, provided they have been rendered insensitive to the radiation used to expose the top resist.

The planarizing ARC layer 5 and the resist 7 should not significantly intermix during processing or the optical properties of the resist may be adversely altered. The resist is sensitive to the radiation, typically at a wavelengths of 0.5µm or less, such as used in submicron pattern delineation. Such radiation is conveniently termed *ultraviolet radiation*. The conventional photoresist is typically spun directly onto the planarizing ARC layer, although other methods may be used to deposit the resist. Because the top surface of the planarizing ARC layer is, in general, not completely planarized, there will be pattern dependent variations in the thickness of the subsquently deposited photoresist. This photoresist is advantageously made a high contrast resist so that in the subsequent optical pattern delineation step there is minimal dependence of feature width on resist thickness, and the sidewalls of the resist are close to vertical. Typically, the sidewalls deviate less than 5 degrees from vertical. Both the antireflection coating and the resist have etching characteristics which will be discussed later.

Those skilled in the an will readily know how to fabricate the structure depicted in FIG. 2, as well as variations thereof, and further description of the fabrication process will not be required after consideration of the following.

FIG. 3 is a sectional view of the same portion of the integrated circuit after the resist has been pattern delineated by exposing selected portions of the resist to radiation and then exposing, i.e., revealing, portions of the antireflection coating by removing selected portions of the resist, typically in a conventional development process. As mentioned, a high-contrast resist is desirable. The term *high* *contrast* means that the resist dissolution characteristic *dt/dE* is greater than 2.5 near the exposure energy needed to clear the resist. Here, *t* is the thickness of developed resist remaining after receiving an exposure E. Those skilled in the art will readily select appropriate techniques for this pattern delineation process, and further description of the pattern delineation process is not required. By suppressing the reflection of exposing radiation at the lower surface of the resist with the ARC, and by using a high-contrast resist, the feature widths, W₉ and W₁₁, will be approximately equal.

The structure depicted in FIG. 3 is now anisotropically etched in, for example, an oxygen plasma at a pressure that is typically 10 mTorr or less. Such a plasma has an extremely high degree of directionality and there is minimal loss of feature width during etching. No attempt is made to obtain a differential etch rate between the photoresist and the underlying planarizing ARC. Both are typically organic polymers, and their etch rates will be similar in the Z-direction which is perpendicular to the horizontal plane of substrate 1. In general, the resist and the planarizing ARC layers combined lose an amount of height equal to *a*(x,y), the thickness of the planarizing ARC layer that needs to be etched. The length of the etch will, at the minimum, permit the maximum thickness of the ARC not protected by photoresist to be cleared. Additionally, there is some overetching to remove an additional amount to account for process non-uniformities. The structure obtained is depicted in FIG. 4. As can be seen, W₉ and W₁₁ are approximately equal. In general, after etching is complete, the polymer surface will be either resist or planarizing ARC depending on the location x,y. Further processing of the revealed portions of the substrate surface may now be performed.

Even with an overetch, the widths of features transferred into the planarizing ARC will be identical to those of the initial photoresist pattern if the etch is perfectly anisotropic and the line edge slopes of the initial photoresist features are vertical.

Departures from strict anisotropicity and vertical line-edge profiles of the initial photoresist features, coupled with the location-dependent thickness of the ARC, generally result in differential feature widths after pattern transfer into the planarizing ARC. In practice, these departures from ideality can be made acceptably small, even for sub half-micron features. In a pure oxygen plasma, systematic linewidth losses of 0.05µm are typical, with critical location-dependent linewidth differentials being much smaller. The systematic linewidth losses during pattern transfer can usually be offset by appropriate biasing of the photomask or reticle and subsequent adjustment of the resist exposure.

Improved anisotropy during the plasma transfer etch into the planarizing ARC can be achieved by an additive or additives to the etchant gas. The additive is useful in controlling the pattern transfer delta (defined as the final pattern width minus the original pattern width) by adjusting the additive/oxygen ratio. One such additive is hydrogen bromide (HBr). A carrier gas, such as He, may or may not be used. With an additive such as HBr, the pattern transfer delta can be adjusted continuously from a negative value (corresponding to linesize loss) to a positive value (corresponding to linewidth gain) as the hydrogen bromide/oxygen ratio is increased. Linewidth gain is believed to be achieved by sidewall deposition of etching products, typically polymers. This method, with its capability of strict anisotropy, has the slight drawback of showing its own pattern sensitivity with sidewall build-up being dependent on the area of surrounding material being etched. Thus isolated features show larger (more positive) etch deltas than tighly-packed features. Strict anisotropy (corresponding to zero etch delta) is therefore only possible for features defined in photoresist in a given environment. At many device levels, this non-ideality is inconsequential, since critical features are usually either essentially isolated or densely packed.

The key advantages of the process described using either doped or undoped O₂ plasma, are its simplicity and low cost; the deviations from ideality are acceptable.

Variations and modifications of the embodiments described will be readily thought of by those skilled in the art. For example, although use of ultraviolet radiation was described, use of X-ray radiation and electron beams is also contemplated for patterning the top resist layer. Another additive to the oxygen plasma that gives the desired sidewall buildup is CHF₃, with or without an inert carrier gas such as He or Ar.

## Claims

1. A method for fabricating semiconductor integrated circuits comprising the steps of:
fabricating a substrate(e.g. 1) having features(e.g. 3);
covering said substrate(e.g. 1) and features(e.g. 3) with a planarizing ARC layer(e.g. 5) comprising a material which is highly absorbing of the radiation used in a subsequent step;
coating said planarizing ARC layer(e.g. 5) with a resist(e.g. 7);
exposing selected portions of said resist(e.g. 7) to radiation, thereby creating at least two features(e.g. 9,11) in said resist(e.g. 7);
and anisotropically etching said resist(e.g. 7) and said planarizing ARC layer(e.g. 5) to reveal selected portions of said substrate(e.g. 1).

2. A method as recited in claim 1 in which said planarizing ARC(e.g. 5) and said resist(e.g. 7) do not mix.

3. A method as recited in claim 1 in which said etching is in a plasma comprising oxygen.

4. A method as recited in claim 1 in which said resist(e.g 7) comprises a high-contrast resist.

5. A method as recited in claim 1 in which said anisotropic etching step removes said resist(e.g. 7) and said antireflection coating(e.g. 5) at approximately the same rate in the direction perpendicular to the horizontal plane of the substrate (e.g. 1).

6. A method as recited in claim 3 in which said plasma further comprises pattern transfer delta controlling additive.

7. A method as recited in claim 6 in which said additive comprises at least one member selected from the group consisting of HBr and CHF₃.

8. A method as recited in claim 6 in which said plasma further comprises an inert carrier gas.
